Europäisches Patentamt

European Patent Office

Office européen des brevets

(11) Veröffentlichungsnummer: **0 005 198**
**B1**

(12) **EUROPÄISCHE PATENTSCHRIFT**

(45) Veröffentlichungstag der Patentschrift:
14.04.82

(51) Int. Cl.³: **C 04 B 35/18**, C 01 B 33/26

(21) Anmeldenummer: **79101133.1**

(22) Anmeldetag: **12.04.79**

(54) Verfahren zur Herstellung eines dichten keramischen Materials mit einem Gehalt an hochreinem Mullit.

(30) Priorität: **08.05.78 US 904112**

(43) Veröffentlichungstag der Anmeldung:
**14.11.79 Patentblatt 79/23**

(45) Bekanntmachung des Hinweises auf die Patenterteilung:
**14.04.82 Patentblatt 82/15**

(84) Benannte Vertragsstaaten:
**DE FR GB**

(56) Entgegenhaltungen:
**DE-A-2 441 308**
**DE-A-2 605 950**
**DE-A-2 330 729**
**DE-B-1 030 753**
**US-A-2 895 840**
**US-A-3 003 887**
**US-A-3 103 443**

(73) Patentinhaber: **International Business Machines Corporation, Armonk, N.Y. 10504 (US)**

(72) Erfinder: **Eggerding, Carl Louis, 64 Kretch Circle, Wappingers Falls, N.Y. 12590 (US)**
Erfinder: **Gonzales, Jr. Frank, 6 Longview Road, Poughkeepsie, N.Y. 12603 (US)**
Erfinder: **Niklewski, Jerzy Bronislaw, 93 Brothers Road, Wappingers Falls, N.Y. 12590 (US)**

(74) Vertreter: **Kreidler, Eva-Maria, Dr. rer. nat., Schönaicher Strasse 220, D-7030 Böblingen (DE)**

Verfahren zur Herstellung eines dichten keramischen Materials mit einem Gehalt an hochreinem Mullit

Die Erfindung betrifft ein Verfahren zur Herstellung eines dichten im wesentlichen glasphasenfreien keramischen Materials mit einem Gehalt an hochreinem Mullit.

Mullit ($3Al_2O_3 \cdot 2SiO_2$) ist seit langem in der Industrie keramischer Werkstoffe und feuerfester Materialien bekannt. Mullit ist eine der stabilsten Komponenten im $Al_2O_3$–$SiO_2$–System. Deshalb ist dieses Material Hauptbestandteil einer grossen Anzahl keramischer Produkte, welche aus Alumosilikatmaterialien hergestellt werden. Beträchtliche Mengen Mullit werden zur Herstellung von Körpern aus keramischem Material verwendet, welche Widerstandsfähigkeit gegenüber hohen Temperaturen aufweisen. Der relativ niedrige thermische Ausdehnungskoeffizient dieser feuerfesten Materialien ist die Ursache dafür, dass Körper aus diesen Materialien thermischen Spannungen besser widerstehen als ähnliche, welche aus Aluminiumoxidmaterialien hergestellt wurden.

Mullit besitzt eine Dielektrizitätskonstante in der Grössenordnung zwischen 5 und 6 und weist deshalb sehr attraktive elektrische Eigenschaften für seine Verwendung in der Technologie integrierter Schaltkreise mit einem Trend zu immer höheren Schaltgeschwindigkeiten auf. Der thermische Ausdehnungskoeffizient des Mullits passt darüber hinaus ausgezeichnet zu dem grosser, integrierte Schaltkreise tragender Siliciumchips oder Gläser, die auf Substraten angebracht werden. Obgleich die Verwendung von Mullit als Substratmaterial für die Herstellung integrierter Schaltkreise bekannt ist, ist die Herstellung von Substraten mit hoher Dichte aus diesen Materialien noch nicht bekannt.

Der im Handel erhältliche Mullit enthält wesentliche Mengen an Verunreinigungen wie Siliciumdioxid, Eisen- und Titanoxid.

Diese Verunreinigungen beeinflussen die physikalischen, elektrischen und chemischen Eigenschaften des Mullits, welche sich ihrerseits auf die keramischen Zusammensetzungen, welche Mullit enthalten, übertragen. Mullit kann nach Verfahren hergestellt werden, die in den US-Patentschriften 3 857 923, 3 922 333, 3 615 778 und 3 336 108 beschrieben sind. Damit Mullit einer keramischen Mischung zugesetzt werden kann, muss es in eine feine Teilchenform gebracht werden. Da Mullit ein sehr hartes Material ist, ist dieses Verfahren sehr teuer, und was noch wesentlicher ist, durch den Mahlprozess werden zusätzliche Verunreinigungen in den Mullit eingeführt.

In dem in der deutschen Offenlegungsschrift 2 330 729 wird dem Problem der Verunreinigung durch Materialabrieb beim Mahlen begegnet, indem Mahlbecher verwendet werden, die aus $Al_2O_3$ und/oder $SiO_2$ bestehen und indem die Mengen der Ausgangsmaterialien so festgelegt werden, dass erst durch das infolge Abriebs zugefügte Material ein Mengenverhältnis der Mischungskomponenten erreicht wird, das eine quantitative Umsetzung zu Mullit ermöglicht.

Nachteilig an diesem Verfahren ist, dass es sehr aufwendig ist.

In der deutschen Auslegeschrift 1 030 753 ist ein Verfahren zur Erzeugung von feuerfesten Körpern aus einer vorgebrannten Mullitformmasse beschrieben, bei dem ein aus Bauxit und Kaolin bestehendes Ausgangsgemisch mit Verunreinigungen von mehr als 1% und einem über das theoretische Mullitverhältnis hinausgehenden leichten Überschuss an $Al_2O_3$ geschmolzen, nach dem Erstarren zerkleinert und nach dem Vermengen mit einem Bindemittel geformt und gebrannt wird. Das in dieser Auslegeschrift beschriebene Material ist nicht dicht und auch nicht porenfrei, so dass es als Substratmaterial in der Halbleitertechnologie nicht geeignet ist. Ausserdem sind in dieser Auslegeschrift Ausgangsmischungen mit siliciumdioxidreichen Gläsern mit einem $SiO_2$-Gehalt zwischen 40 und 80% nicht beschrieben.

In der US-Patentschrift 3 103 443 ist ein Verfahren zur Herstellung eines Mullitporzellans beschrieben, bei dem als Ausgangsmaterial eine Mischung aus Mullitziegelmehl, Bindeton und Kaolinton eingesetzt wird. Durch diese Patentschrift wird die vorliegende Erfindung weder vorweggenommen, noch nahegelegt.

Versuche zur Herstellung hochreinen Mullits aus Aluminiumoxid und Siliciumdioxid sind sehr teuer und zeitaufwendig, weil Aluminiumoxid und Siliciumdioxid zueinander durch den Mullit hindurch diffundieren müssen, der sich an der Grenzfläche zwischen beiden Materialien ausbildet. Diese Diffusion ist so langsam, dass ein wiederholtes Erhitzen und ein Mahlen zwischen jedem Erhitzen erforderlich ist. Es sind Temperaturen von mindestens 1500°C und darüber erforderlich. Deshalb wurde trotz eines Bedürfnisses bisher kein praktisch durchführbarer kommerzieller Prozess zur Herstellung hochreinen Mullits beschrieben. Es ist besonders erwünscht, keramische Zusammensetzungen mit verschiedenen Konzentrationen an Mullit herstellen zu können, wodurch keramische Materialien mit bestimmten physikalischen, elektrischen und chemischen Eigenschaften erhalten werden.

Aufgabe der Erfindung ist ein Verfahren zur Herstellung von hochreinem Mullit, bzw. ein Verfahren zur Herstellung eines dichten keramischen Materials mit einem Gehalt an Mullit in den gewünschten Konzentrationen.

Die Aufgabe der Erfindung wird gelöst durch ein Verfahren, dessen Merkmale im kennzeichnenden Teil des Patentanspruchs 1 niedergelegt sind. Vorteilhafte Ausgestaltungen der Erfindung sind in den Unteransprüchen niedergelegt.

Mit dem erfindungsgemässen Verfahren können keramische Materialien mit jedem gewünschten Gehalt an hochreinem Mullit hergestellt werden. Der Mullitanteil kann dabei zwischen etwa 10 oder 100% variieren. Das erfindungsgemässe Verfahren ist wesentlich weniger aufwendig und daher billiger durchzuführen als bisher bekannte Verfahren, bei denen das Material mehrmals erhitzt werden musste und zwischen jedem Erhitzen ein Mahlen erforderlich war.

Die Erfindung wird anhand der nachfolgenden speziellen Beschreibung der Ausführungsbeispiele näher erläutert.

In dem erfindungsgemässen Verfahren wird eine teilchenförmige Mischung hergestellt mit einem Gehalt an $\alpha$-$Al_2O_3$ und $SiO_2$, welches in Form von Alumosilikatglas zugegeben wird. In der Mischung ist mindestens auch eine relativ kleine Menge, mindestens 3% Mullit enthalten. Wenn die Mischung erhitzt wird, wirkt der zuerst zugegebene Mullit als Keim, welcher die Bildung von Mullit aus $Al_2O_3$ und $SiO_2$ bewirkt. Jede gewünschte Menge an Mullit bis im wesentlichen zu 100% kann gebildet werden. Zur Bildung von keramischem Material, das zu 100% aus Mullit besteht, müssen die stöchiometrischen Mengen von $Al_2O_3$ und $SiO_2$, welches als Glas zugegeben wird, mit den anfänglich zugegebenen Mullitkeimen kombiniert werden. Während des Sinterns wird aus den Komponenten Mullit gebildet. Wenn weniger als 100% Mullit gewünscht wird, muss der Gesamtgehalt an Aluminiumoxid zu Siliciumdioxid gegenüber dem stöchiometrischen Verhältnis in einem Überschuss vorhanden sein.

Nach der Reaktion erhält man den gewünschten Mullit und die $\alpha$-Aluminiumoxid-Phasenstruktur. Die Glasphase ist dann aufgebraucht. Das Glas wirkt als Flussmittel während des Sinterns, welches die Mullitbildungsreaktion beschleunigt. Andere keramische Materialien können der speziellen Mischung einverleibt werden, damit die gewünschten physikalischen, elektrischen oder chemischen Eigenschaften in dem gesinterten Keramikmaterial erhalten werden.

Die teilchenförmige Mischung wird vorzugsweise mit einem organischen Bindemittel, einem Lösungsmittel und einem Weichmacher vermischt unter Erhalt einer Aufschlämmung, welche mittels einer Rakel aufgetragen und zu keramischen grünen Blättern getrocknet werden kann, wie beispielsweise in der US-Patentschrift 2 966 719 beschrieben ist. In der grünen Keramik wird dann ein Lochmuster erzeugt, ein metallisches Leiterzugmuster wird mittels Siebdruck aufgetragen, eine Vielzahl von Blättern wird laminiert und die resultierende Einheit zur Ausbildung eines mehrschichtigen Keramiksubstrats gesintert.

Dass es erwünscht ist, verschiedene Mengen von Mullit in keramische Materialien, welche als Halbleitersubstrate verwendet werden, einzuführen, ist ersichtlich, wenn man die Ausdehnungskoeffizienten von Mullit, Silicium und anderen keramischen Materialien betrachtet. Der Ausdehnungskoeffizient von reinem Mullit von Zimmertemperatur bis 300°C liegt bei $40 \times 10^{-7}$/°C. Der Ausdehnungskoeffizient von $Al_2O_3$ ist $75 \times 10^{-7}$/°C, und typische Keramik mit einem hohen Oxidgehalt hat einen Ausdehnungskoeffizienten in der Grössenordnung von $70 \times 10^{-7}$/°C. Der Ausdehnungskoeffizient von Molybdän, welches als leitendes Metall zur Herstellung von Leiterzugmustern auf Mehrschichtkeramiksubstraten aus feuerfestem Material verwendet wird, liegt bei $55 \times 10^{-7}$/°C und damit zwischen dem Wert für Keramik mit hohem Aluminiumoxidgehalt und Mullit. Eine Anpassung der Ausdehnungskoeffizienten von Molybdän und einem keramischen Subtratmaterial kann durch die geeignete Menge Mullit erreicht werden, wodurch eine Rissbildung, ein Verziehen und innere Spannungen des Substrats bei Anwendung einer Molybdänmetallurgie vermieden werden. Auch ein Substrat aus reinem Mullit würde eine gute Anpassung seines Ausdehnungskoeffizienten an Silicium ergeben, welches einen Ausdehnungskoeffizienten von $32 \times 10^{-7}$/°C aufweist. Ein Substrat dieser Art wäre dann von Wichtigkeit, wenn eine Siliciumhalbleitervorrichtung durch Löten mit diesem Substrat verbunden wird.

Die Dielektrizitätskonstante von Mullit liegt zwischen 5 und 6 und die Dielektrizitätskonstante einer Keramik mit hohem Aluminiumoxidgehalt in der Grössenordnung von 9 bis 9,5. Durch Anwendung von Mullit in einem Keramikmaterial würde dessen Dielektrizitätskonstante herabgesetzt, was von Bedeutung ist für die Herabsetzung der Induktanz bei Anwendungen mit hohen Schaltgeschwindigkeiten.

Mit dem erfindungsgemässen Verfahren ist es möglich, eine dichte Keramik mit einem sehr niedrigen oder gar keinem Gehalt an Glasphase herzustellen. Der chemische Angriff eines keramischen Materials erfolgt im allgemeinen an der Glasphase. Daher kann das erfindungsgemässe Verfahren angewendet werden, um einen Keramikörper mit verbesserter chemischer Widerstandsfähigkeit zu erhalten.

Zur Herstellung der Makroteilchen wird das Aluminiumoxid in Form von $\alpha$-$Al_2O_3$ mit einem Reinheitsgrad grösser 99%, welches im Handel erhätlich ist, angewendet. Als Mullit, welcher als Keimbildungsmaterial verwendet wird, kann jedes beliebige Mullitmaterial einschliesslich im Handel erhältlicher Mullite mit einer Reinheit grösser 90% verwendet werden. Die Verunreinigungen, die in dem als Keimbildungsmaterial verwendeten Mullit vorhanden sind, beeinträchtigen, wenn dieses in dem Körper dispergiert wird, die elektrischen, chemischen und physikalischen Eigenschaften des resultierenden keramischen Materials nicht nachteilig. Jedes geeignete Glas, welches einen hohen Gehalt an Siliciumdioxid aufweist, kann zur Durchführung der Erfindung verwendet werden. In einer praktischen Anwendung wird das Mullitkeimbildungsmaterial zu einem bestehenden Glas, welches sowohl Siliciumdioxid wie Aluminiumoxid enthält, zugefügt. Ein typisches Glas zur Durchführung des erfindungsgemässen Verfahrens enthält beispielsweise 52 Gewichtsprozent $SiO_2$, 31 Gewichtsprozent $Al_2O_3$, 10 Gewichtsprozent MgO und 7 Gewichtsprozent CaO. Wenn Mullit zu diesem Glas zugefügt und die Mischung gesintert wird, reagieren das Aluminiumoxid und das Siliciumdioxid des Glases in einem Verhältnis von 72:28 unter Bildung von weiterem Mullit.

Die Gläser, die in dem erfindungsgemässen Verfahren verwendet werden, sind Alumosilikatgläser, wobei deren Viskosität bei der Brenntemperatur und die erforderliche Menge an Siliciumdioxid die bestimmenden Faktoren sind. Ein zu flüssiges Glas führt zu einer Deformation des Körpers, während eine zu hohe Viskosität zu einem zu langsamen Verlauf der Reaktion führt. Die Glaszusammensetzung sollte ein Siliciumdioxidgehalt zwischen 80 und 40% aufweisen. Die Teilchengrösse der teilchenförmigen Mischung gemäss der Erfindung liegt vorzugsweise in einem Bereich unter einer Teilchengrösse, die einer lichten Maschenweite von 0,044 mm (325 mesh) entspricht. Es kann jedoch auch, wenn es gewünscht wird, eine andere Teilchengrösse gewählt werden. Der tatsächlich mögliche Feinheitsgrad der Teilchen wird bestimmt durch die Schwierigkeiten, die bei der Herstellung der gewünschten Formkörper auftreten. Die maximale Korngrösse des verwendeten Pulvers wird durch die Länge der Zeit, die zur vollständigen Durchführung der Reaktion erforderlich ist, bestimmt. Je grobkörniger das Pulver ist, um so länger muss der Körper gesintert werden. Das erfindungsgemässe Verfahren ist bevorzugt bei der Mehrschichtkeramiktechnologie anwendbar, bei der das teilchenförmige Material mit einem Bindemittel, einem Lösungsmittel und einem Weichmacher gemischt wird, die resultierende Aufschlämmung mittels einer Rakel aufgetragen und zu einem grünen Keramikblatt getrocknet wird. Zur Formgebung können jedoch auch andere Verfahren angewendet werden, beispielsweise das Trockenpressen, Extrudieren, Druckpressen, das Verformen mit einer sich drehenden Form oder das Spritzgussverfahren. Als Sinteratmosphäre, die bei der Durchführung des erfindungsgemässen Verfahrens angewendet wird, kommt entweder nasser Wasserstoff, Luft, eine Mischung aus Wasserstoff und Stickstoff, Stickstoff, Argon oder irgendeine andere geeignete Umgebung in Frage. Im allgemeinen beeinflusst die Natur der Gasatmosphäre die Mullitbildung nicht. Es können jedoch verschiedene Atmosphären erwünscht sein, um nachteilige Effekte auf die Metallurgie, die mit dem Keramiksubstrat verbunden ist, auszuschalten. Die Sintertemperatur in dem erfindungsgemässen Verfahren liegt im allgemeinen in einem Bereich von 1300 bis 1800°C, vorzugsweise in dem Bereich 1350 bis 1600°C, bzw. in dem Bereich von 1450 bis 1550°C. Die erforderliche Sinterzeit variiert in Abhängigkeit von der Natur der teilchenförmigen Mischung und der Körnigkeit der Teilchen. Die Sinterzeit liegt im allgemeinen zwischen einer halben bis 24 Stunden und vorzugsweise in einem Bereich von einer bis sechs Stunden. Die Teilchengrösse der Komponenten der teilchenförmigen Mischung kann beliebig sein und liegt im allgemeinen zwischen 100 nm und einer Teilchengrösse, die einer lichten Maschenweite von 2,35 mm (8 mesh) entspricht, und vorzugsweise bei einer Teilchengrösse unter einer lichten Maschenweite von 0,044 mm (325 mesh). Die Mullitkomponente in der teilchenförmigen Mischung ist in einer solchen Menge vorhanden, dass genügend Keime vorliegen. Die bevorzugte Menge liegt zwischen 3 und 90 Gewichtsprozent, vorzugsweise zwischen 5 und 30 Gewichtsprozent. Die Menge an $SiO_2$ in der Mischung kann beliebig sein und bis zu der stöchiometrischen Menge, die eine Endmischung mit bis zu 100% Mullit ergibt, betragen. Es können jedoch auch kleinere Mengen verwendet werden.

Beispiel 1

Eine Mischung aus 20 Gewichtsteilen Mullit, 11 Gewichtsteilen Glas und 69 Gewichtsteilen $\alpha$-Aluminiumoxid wurde in eine Kugelmühle gebracht. Eine organische Mischung, bestehend aus 21 Gewichtsteilen Methanol, 63 Gewichtsteilen Methylisobutylketon, 3 Gewichtsteilen Dipropylenglykoldibenzoat und 12 Gewichtsteilen Polyvinylbutyral wurde zugefügt, so dass das Gewichtsverhältnis von keramischem zu organischem Material bei 1,82 lag. Die Mischung wurde gemahlen, so dass alle Teilchen durch ein Sieb mit einer lichten Maschenweite von 0,044 mm (325 mesh) gingen. Die Aufschlämmung wurde entlüftet und mittels einer Rakel auf einen sich bewegenden organischen Film aufgetragen unter Ausbildung eines grünen keramischen Blattes. Das Blatt wurde dann getrocknet und in die entsprechende Grösse geschnitten. Zehn grüne Blätter wurden in einer Hohlform bei einer Temperatur von 95°C und einem Druck von 20 699 100 Pa laminiert.

Die Proben wurden dann in einen Brennofen gebracht und in einer nassen Wasserstoffatmosphäre auf 1560°C erhitzt. Die Proben wurden 3 Stunden lang bei dieser Temperatur gehalten. Die gebrannten Proben waren dicht und wiesen keine sichtbare Porosität auf.

Nach dem Abkühlen wurden die Proben zu einem Pulver vermahlen mit einer Teilchengrösse, die einer lichten Maschenweite von 0,074 mm (200 mesh) entsprach. Dieses Pulver wurde analysiert unter Verwendung eines Röntgenstrahl-Pulver-Diffraktometers mit Cu K$\alpha$-Strahlung. Die Ergebnisse wurden mit den ASTM-Röntgenstrahldaten verglichen. In der Röntgenstrahlaufzeichnung fehlte die sehr breite Bande vollständig, die die Silikatglasphase anzeigt. Als einzige Kristallphasen könnten die von Aluminiumoxid und Mullit detektiert werden.

Dieses Beispiel zeigte, dass, wenn das Aluminiumoxid zu Glas-Verhältnis in dem Rohmaterial so lag, dass ein Überschuss von Aluminiumoxid vorhanden war, die in situ Mullit-Synthesereaktion so lange stattfand, bis alles $SiO_2$ aufgebraucht war. Die Menge an Aluminiumoxid, die im Überschuss zum stöchiometrischen Verhältnis vorhanden war, reagierte nicht und blieb als kristallines $\alpha$-Aluminiumoxid zurück.

Beispiel 2

Eine Mischung aus 74,5 Teilen Mullit, 14,5 Teilen $\alpha$-Aluminiumoxid und 11 Teilen Glaspulver wurde in der in Beispiel 1 beschriebenen Weise verarbeitet. Nach einem dreistündigen Sintern bei 1560°C wurde eine Probe zu einer Teilchengrösse gemahlen, die einer lichten Maschenweite von unter 0,074 mm (200 mesh) entsprach, und das Pulver wurde analysiert unter Anwendung eines Rontgenstrahldiffraktometers und des Verfahrens, das in Beispiel 1 beschrieben ist.

Die Ergebnisse dieser Untersuchung zeigten, dass keine kristalline $\alpha$-Aluminiumoxidphase zurückblieb. Das Aluminiumoxid zu Glas-Verhältnis in dieser Zusammensetzung war so ausgelegt, dass das stöchiometrische Verhältnis, welches vollständig unter Bildung von Mullit reagiert, erhalten wurde. Die Ergebnisse zeigen, dass die Reaktion so wie vorhergesagt verlief, ohne dass kristallines Aluminiumoxid zurückblieb.

Beispiel 3

Eine weitere Probe wurde wie in Beispiel 1 angegeben hergestellt, mit der Ausnahme, dass das keramische Rohmaterial aus 30 Gewichtsteilen Mullit, 11 Gewichtsteilen Glaspulver und 59 Gewichtsteilen $\alpha$-Aluminiumoxid bestand. Nach dem Spritzgussverformen, dem Trocknen, Laminieren und Sintern, das wie in Beispiel angegeben durchgeführt wurde, wurde ein Teil der Probe befestigt und poliert unter Anwendung der in der Metallographie üblichen Verfahren. Die Probe wurde dann analysiert unter Verwendung eines optischen Mikroskops, auf dem ein Mikrometertisch mit einer registrierenden Vielfachmikrometervorrichtung befestigt war. Diese Vorrichtung wurde verwendet, um quantitativ nach einer statistischen Methode die Volumanteile der vorhandenen Phasen zu messen. Eine umfassende Analyse zeigte, dass die zuvor angegebene Zusammensetzung ein Verhältnis von 55,9 Vol.% Mullitphase und 44,1 Vol.% $\alpha$-Aluminiumoxidphase aufwies. Nur ein Rückstand von weniger als 2 Vol.% Glasphase konnte in dieser Zusammensetzung beobachtet werden. Aus Phasengleichgewichtsdiagrammen für das $Al_2O_3$-$SiO_2$-System ist ersichtlich, dass die zu erwartenden Phasen Mullit und Aluminiumoxid in einem Volumenverhältnis von 55:45 sind. Deshalb zeigt dieses Beispiel, dass durch Zufügen von Mullit zu einer Zusammensetzung mit einem Gehalt an Aluminiumoxid und einem Alumosilikatglas der Mullit-Impfschritt in der Glasphase umgangen wird und das Wachsen der Mullitphase durch die Reaktion zwischen der Aluminiumoxid- und der Glasphase stattfindet unter Erhalt zusätzlichen Mullits. Der beobachtete Porositätsgrad und das Material, das während des Polierens durch Beschädigung der Oberfläche abgetragen wurde, wurden gemessen, und es wurde gefunden, dass die Poren diskontinuierlich sind und weniger als 7,6 Vol.% betragen. Daher gestattet dieses Verfahren die Herstellung sehr dichter Mullitproben.

Beispiel 4

Die Mullitbildung als Funktion der Mullitmengen, von denen ausgegangen wird, wurde gemessen, indem Körper, wie in Beispiel 1 angegeben, aus verschiedenen Ausgangsmaterialien hergestellt und 3 Stunden lang bei 1560°C gebrannt wurden. Die Prozentgehalte an Mullit wurden aus Röntgenstrahlenbeugungsbildern berechnet.

| Ausgangsmaterialien in Gewichtsprozent | | | Gebrannter Mullit in Gewichtsprozent |
|---|---|---|---|
| % Mullit | % Glas | % $\alpha$-Aluminiumoxid | |
| 5 | 11 | 84 | 7 |
| 10 | 11 | 79 | 13 |
| 15 | 11 | 74 | 22 |
| 20 | 11 | 69 | 27 |
| 25 | 11 | 64 | 35 |
| 30 | 11 | 59 | 45 |

| Probe | Glasteilchen pro 200 Teilchen |
|---|---|
| A | 1 |
| B | 0 |

Die Ergebnisse zeigen, dass die Mengen an gebildetem Mullit zwischen 30 und 50% verglichen mit den Ausgangsmengen variieren und dass die Leichtigkeit der Mullitbildung mit grösseren Mullitzugaben, welche zusätzliche Keime darstellten, zunahm. Die Glas-Aluminiumoxid-Reaktion zu Mullit verlief nicht bis zu Ende in den Fällen, in denen weniger als 30% Mullit und 11% Glas vorhanden war, was auf die Heterogenität in dem keramischen Körper, die die Reaktion begrenzte, zurückzuführen war.

Beispiel 5

Die folgenden Zusammensetzungen an Rohmaterial wurden hergestellt wie in Beispiel 1:
A. 3 Gewichtsteile Mullit, 21,8 Gewichtsteile Glaspulver, 75,2 Gewichtsteile Aluminiumoxid;
B. 5 Gewichtsteile Mullit, 20,7 Gewichtsteile Glaspulver, 74,3 Gewichtsteile $\alpha$-Aluminiumoxid.
Die Proben A und B wurden in Luft 3 Stunden lang bei 1319°C und 1328°C gesintert.

Teile dieser Proben wurden auf mit Kohlenstoff beschichteten Elektronenmikroskopgittern befestigt. Unter Verwendung eines Transmissionselektronenmikroskops und einer defokussierten Elektronenbeugungsmethode konnte die Menge der Glasphase bestimmt werden. Bei beiden Zusammensetzungen wurden 200 Teilchen geprüft, um festzustellen, ob die Teilchen kristallin (entweder Mullit oder Aluminiumoxid) oder amorph, d.h. Glasteilchen waren. Die Ergebnisse sind folgende:

Ohne Aufbrauchen der Glasphase wäre eine Zahl von ungefähr 40 zu beobachten gewesen.

Die Zusammensetzungen der Proben A und B sollten einen Überschuss an Aluminiumoxid aufweisen. Die Glasphase sollte aufgebraucht sein. Wie aus den zuvor angegebenen Ergebnissen ersichtlich ist, war dies tatsächlich der Fall. Die Mullitbildungsreaktion verlief vollständig bei 1320°C.

Beispiel 6 (Vergleichsbeispiel)

Eine α-Aluminiumoxid-Glas-Mischung mit einer Zusammensetzung von 89 Gewichtsteilen α-Aluminiumoxid und 11 Gewichtsteilen Glas wurde wie in Beispiel 1 angegeben hergestellt und bei 1560°C drei Stunden lang gesintert. Die Probe wurde gemahlen und durch ein Sieb mit einer Maschenweite von 0,074 mm (200 mesh) gegeben. Ein Röntgenstrahl-Beugungsbild des Pulvers wurde aufgenommen unter Anwendung von Cu Kα-Strahlung. Nur α-Aluminiumoxid war in dem Röntgenstrahl-Beugungsbild zu sehen, wohingegen Mullit vollständig fehlte.

Die Glasphase wurde auch untersucht unter Verwendung der Transmissionselektronenmikroskopie, wie in Beispiel 5 beschrieben. Es wurden 11 Glasteilchen gefunden, was das Vorhandensein der Glasphase anzeigte.

## Patentansprüche

1. Verfahren zur Herstellung eines dichten im wesentlichen glasphasenfreien keramischen Materials mit einem Gehalt an hochreinem Mullit und gegebenenfalls an α-Al₂O₃, dadurch gekennzeichnet, dass man eine Mischung aus

(1) mindestens 3 Gew.-% Mullitteilchen,

(2) α-Aluminiumoxidteilchen in einer mindestens gleich der für die stöchiometrische Zusammensetzung von Mullit erforderlichen Menge und

(3) Alumosilikatglasteilchen in einer zur Reaktion von Siliciumdioxid mit Aluminiumoxid zu einem gewünschten Mullitgehalt ausreichenden Menge

bei einer Temperatur zwischen 1300 und 1800°C sintert.

2. Verfahren nach Anspruch 1, dadurch gekennzeichnet, dass man die Mischung ½ bis 24 Stunden, vorzugsweise 6 Stunden lang bei einer Temperatur zwischen 1350 und 1600°C, vorzugsweise zwischen 1450 und 1550°C sintert.

3. Verfahren nach Anspruch 1, dadurch gekennzeichnet, dass Mullit-, Aluminiumoxid- und Glasteilchen mit einer Teilchengrösse zwischen 100 nm und einer Grösse, die 2,35 mm lichter Maschenweite entspricht, verwendet werden.

4. Verfahren nach den Ansprüchen 1 und 3, dadurch gekennzeichnet, dass in der Mischung Mullitteilchen in einer Menge von 3 bis 90 Gewichtsprozent, vorzugsweise 5 bis 30 Gewichtsprozent, verwendet werden.

5. Verfahren nach den Ansprüchen 1, 3 und 4, dadurch gekennzeichnet, dass man eine Mischung aus Mullitteilchen in einer Menge von 5 bis 30 Gewichtsprozent, α-Aluminiumoxidteilchen und Alumosilikatglas verwendet.

6. Verfahren nach einem oder mehreren der Ansprüche 1 bis 5, dadurch gekennzeichnet, dass die Mischung aus Mullit-, Aluminiumoxid- und Glasteilchen mit einem organischen Bindemittel und einem Weichmacher in einem Lösungsmittel dispergiert und aus der flüssigen Dispersion grüne Keramik hergestellt wird.

7. Verfahren nach Anspruch 6, dadurch gekennzeichnet, dass aus der flüssigen Dispersion mittels einer Rakel Keramikblätter hergestellt und diese nach dem Trocknen laminiert und unter Ausbildung eines dichten Keramikkörpers gesintert werden.

8. Verfahren nach Anspruch 6, dadurch gekennzeichnet, dass als Bindemittel Polyvinylbutyral verwendet wird.

## Claims

1. Method of making a dense ceramic material substantially without a glass phase, the material containing high purity mullite and if desired an α-Al₂O₃, characterized in that a mixture of 1. at least 3% by weight of mullite particles 2. α-Aluminium oxide particles in a quantity at least equalling that required for the stoichiometric composition of mullite and 3. aluminosilicate glass particles in a quantity sufficient for the reaction of silicon dioxide with aluminium oxide to form a desired mullite content, is sintered between 1300 and 1800°C.

2. Method as claimed in claim 1, characterized in that the mixture is sintered for a period between ½ to 24 hours, preferably for 6 hours at temperature between 1350 and 1600°C, preferably between 1450 and 1550°C.

3. Method as claimed in claim 1, characterized in that mullite, aluminiumoxide, and glass particles are used with a particle size between 100 nm and a size corresponding to 2,35 mm mesh.

4. Method as claimed in claims 1 and 3, characterized in that in the mixture mullite particles in a quantity of 3 to 90% by weight, preferably 5 to 30% weight are used.

5. Method as claimed in claims 1, 3 and 4, characterized in that a mixture of mullite particles in a quantity of 5 to 30% by weight, α-aluminium oxide particles, and aluminosilicate glass is used.

6. Method as claimed in any one of claims 1 to 5, characterized in that the mixture of mullite, aluminiumoxide, and glass particles is dispersed with an organic binder and a plasticizer in a solvent, and that green ceramic is made of the fluid dispersion.

7. Method as claimed in claim 6, characterized in that ceramic sheets are made of the fluid dispersion, and that these sheets are laminated after drying, and sintered to form a dense ceramic body.

8. Method as claimed in claim 6, characterized in that polyvinyl butyral is used as a binder.

## Revendications

1. Procédé pour fabriquer un matériau céramique dense, essentiellement exempt de phase de verre, et contenant de la mullite très pure et éventuellement un α-Al₂O₃, caractérisé en ce que l'on fritte, à une température comprise entre 1300 et 1800°C, un mélange composé de:

(1) particules de mullite dont le pourcentage en poids est d'au moins 3%,

(2) particules d'oxyde d'aluminium-α dans une quantité qui est au moins égale à celle nécessaire pour la composition stoïchiométrique de mullite, et

(3) particules de verre d'aluminosilicate dans une quantité suffisante pour la réaction du dioxyde de silicium avec l'oxyde d'aluminium pour obtenir la teneur en mullite désirée.

2. Procédé selon la revendication 1, caractérisé en ce que l'on fritte le mélange pendant une durée comprise entre une ½ heure et 24 heures, de préférence pendant 6 heures, à une température comprise entre 1350 et 1600°C, de préférence entre 1450 et 1550°C.

3. Procédé selon la revendication 1, caractérisé en ce que les particules de mullite, d'oxyde d'aluminium et de verre untilisées ont une dimension de particule comprise entre 100 nm et une valeur correspondant à une maille de 2,35 mm.

4. Procédé selon l'une des revendications 1 et 3, caractérisé en ce que l'on utilise, dans le mélange, des particules de mullite dans une quantité de 3 à 90% en poids, de préférence de 5 à 30% en poids.

5. Procédé selon les revendications 1, 3 et 4, caractérisé en ce que l'on utilise un mélange de particules de mullite dans une quantité de 5 à 30% en poids, de particules d'oxyde d'aluminium-α et de verre d'aluminosilicate.

6. Procédé selon l'une quelconque des revendications 1 à 5, caractérisé en ce que l'on disperse, dans un solvant, le mélange de particules de mullite, d'oxyde d'aluminium et de verre avec un liant organique et un agent amollissant, et on produit, à partir de la dispersion liquide, de la céramique crue.

7. Procédé selon la revendication 6, caractérisé en ce que l'on utilise une raclette pour produire, à partir de la dispersion liquide, des feuilles de céramique et en ce que l'on lamine ces feuilles après séchage et on les fritte afin de former une céramique dense.

8. Procédé selon la revendication 6, caractérisé en ce que l'on utilise du polyvinyl butyral comme liant.